# FASCICULE DE BREVET EUROPEEN

(11) **EP 2 568 780 B1**
(45) Date de publication et mention de la délivrance du brevet: **09.04.2014**
(21) Numéro de dépôt: 12183232.3
(22) Date de dépôt: 05.09.2012
(51) Int. Cl.: H05K 1/16, G01R 33/00, H01F 17/00, H01F 27/28, H02K 3/26, H05K 3/46

(54) **Anneau magnétique bobiné**
Magnetring einer Spule
Coiled magnetic ring

(30) Priorité: 07.09.2011 FR 1157937
(43) Date de publication de la demande: 13.03.2013
(73) Titulaire: Commissariat à l'Énergie Atomique et aux Énergies Alternatives, 75015 Paris (FR)
(72) Inventeur: Klein, Philippe, 38830 Saint Pierre d'Allevard (FR)
(74) Mandataire: Colombo, Michel

(56) Documents cités:
- EP-A2- 0 917 163
- EP-A2- 1 168 387
- FR-A1- 2 379 229
- FR-A1- 2 877 163

## Description

L'invention concerne un anneau magnétique bobiné et, en particulier, un anneau magnétique bobiné réalisé à partir d'un circuit imprimé.

Un circuit imprimé, également plus connu sous l'acronyme PCB (Printed Circuit Board), est un support permettant de relier électriquement un ensemble de composants électriques. Un tel circuit imprimé se présente généralement sous la forme d'une plaque stratifiée. Ce circuit imprimé peut être monocouche ou multicouche. Un circuit imprimé monocouche ne comporte qu'une seule couche de métallisation dans laquelle sont imprimées des pistes conductrices qui raccordent électriquement les différents composants électriques entre eux. Un circuit imprimé multicouche comporte, au contraire, plusieurs couches de métallisation c'est-à-dire au moins deux couches et, de préférence, plus de quatre ou six couches. Dans la suite de cette description, on s'intéresse principalement à ces circuits imprimés multicouches.

Une couche de métallisation est l'une des couches de la plaque stratifiée formant le circuit imprimé dans laquelle sont réalisées une ou plusieurs pistes conductrices qui raccordent électriquement les différents composants électriques entre eux. Cette couche est plane et s'étend parallèlement au plan de la plaque stratifiée. Généralement, la couche de métallisation est obtenue en déposant une couche uniforme d'un matériau conducteur, typiquement un métal tel que du cuivre, puis en gravant cette couche uniforme pour ne laisser subsister que les pistes conductrices.

Les différentes couches de métallisation du circuit imprimé sont espacées mécaniquement les unes des autres par des couches isolantes en matériau électriquement isolant. Ce matériau isolant présente une rigidité diélectrique élevée c'est-à-dire typiquement supérieure à 3 MV/m et, de préférence, supérieure à 10 MV/m. Par exemple, le matériau électriquement isolant est réalisé à partir de résine époxyde et/ou de fibre de verre. La couche isolante se présente généralement sous la forme d'une plaque rigide réalisée dans un matériau qui ne devient pas visqueux lors de son assemblage avec d'autres couches. Par exemple, elle est réalisée à partir d'une résine thermodurcissable qui a déjà subi un thermodurcissement irréversible.

Les différentes couches du circuit imprimé multicouche sont assemblées les unes aux autres, sans aucun degré de liberté, à l'aide de couches adhésives appelées « pré-imprégné » et plus connues sous le terme anglais de « prepreg ».

Un pré-imprégné est constitué d'une résine thermodurcissable imprégnant, généralement, un renfort tel qu'un tissu. Typiquement, la résine est une résine époxyde. Lors de la fabrication du circuit imprimé, la transformation de la résine thermodurcissable fait intervenir une polymérisation irréversible qui transforme le pré-imprégné en un matériau solide et rigide qui colle entre elles de façon irréversible les différentes couches du circuit imprimé. Typiquement, chaque transformation intervient lorsque le pré-imprégné est chauffé à une température élevée et est comprimé avec une pression élevée. Ici, une température élevée est une température supérieure à 100°C et, de préférence supérieure à 150°C. Une pression élevée est une pression supérieure à 0,3 MPa et, typiquement, supérieure à 1 MPa.

Les pistes conductrices des différentes couches de métallisation peuvent être électriquement raccordées par l'intermédiaire de plots conducteurs traversant les couches isolantes. Les plots conducteurs sont plus connus sous le terme de « vias ». Les vias s'étendent généralement perpendiculaires au plan des couches. Il existe différentes façons de fabriquer ces vias. L'une des plus communes consiste à réaliser un trou dans la ou les couches isolantes à traverser puis à recouvrir d'un métal la paroi intérieure de ces trous. On parle alors de trous métallisés.

Un via ne traverse pas nécessairement toutes les couches du circuit imprimé. Ainsi, il existe des vias borgnes qui débouchent sur une seule face extérieure du circuit imprimé. Aujourd'hui, il est également possible de réaliser des vias « enterrés », par exemple, à l'aide de technologies connues telles que la technologie connue sous l'acronyme de HDI (« High Density of Integration »). Un via enterré ne débouche sur aucune des faces extérieures du circuit imprimé. Par exemple, un via enterré permet de raccorder électriquement des pistes conductrices réalisées dans des couches de métallisation enfouies à l'intérieur du circuit imprimé.

Des anneaux magnétiques bobinés connus comportent :
- un circuit imprimé comportant :
   - un empilement le long d'une direction verticale de plusieurs couches de métallisation séparées mécaniquement les unes des autres par des couches électriquement isolantes,
   - au moins une première bobine qui s'étend le long d'un premier axe vertical d'enroulement, les spires de cette bobine étant formée par des pistes conductrices, réalisées dans des couches de métallisation respectives, raccordées électriquement les unes aux autres par des plots traversant au moins l'une des couches électriquement isolantes,
   - un premier et un second trous verticaux traversant de part en part le circuit imprimé, le premier trou s'étendant le long du premier axe vertical,
- un anneau magnétique.

De tels anneaux magnétiques bobinés sont par exemple utilisés pour la réalisation de capteur de champ magnétique.

En particulier, dans les anneaux magnétiques bobinés connus, l'anneau magnétique est déposé dans les trous verticaux par électrolyse.

De l'état de la technique est également connu de :
- EP0917163A2,
- FR2379229A1,
- EP1168387A2,
- FR2877163A1.

L'invention vise à améliorer la fabrication de tels anneaux magnétiques bobinés. Elle a donc pour objet un anneau magnétique bobiné dans lequel l'anneau magnétique est formé d'une partie supérieure en « U » et d'une partie inférieure en « U », chaque partie supérieure et inférieure comportant deux branches verticales introduites chacune dans un trou respectif du circuit imprimé, chaque branche de la partie supérieure se superposant, à l'intérieur du trou respectif et dans une direction horizontale, sur la branche correspondante de la partie inférieure pour établir la continuité magnétique entre ces deux parties de l'anneau magnétique.

Dans l'anneau magnétique bobiné ci-dessus, la réalisation de l'anneau magnétique grâce à deux parties en « U » emboîtées dans les trous permet d' améliorer la fabrication de l'anneau magnétique et de ne plus avoir recours à une étape d'électrolyse pour déposer cet anneau magnétique.

De plus, cela se traduit par l'existence d'un jeu entre les parois verticales des trous et les faces en vis-à-vis des branches. Ce jeu limite les contraintes mécaniques exercées par le circuit imprimé sur l'anneau magnétique. Or, toute contrainte mécanique sur l'anneau magnétique altère ses propriétés magnétiques par magnétostriction. Un tel anneau magnétique bobiné permet donc, par exemple, d'améliorer la précision du capteur de champ magnétique dans lequel il est utilisé.

Les modes de réalisation de cet anneau magnétique bobiné peuvent comporter une ou plusieurs des caractéristiques suivantes :
■ les dimensions transversales, c'est-à-dire parallèlement au plan des couches de métallisation, de la superposition des branches verticales sont plus petites d'au moins 5 µm que les dimensions transversales correspondantes des trous ou d'un guide rigide logé à l'intérieur de ces trous, pour ménager un jeu entre des parois verticales du trou ou du guide rigide et des faces verticales en vis-à-vis de l'anneau magnétique ;
■ les trous sont oblongs et s'étendent le long d'un même axe horizontal d'alignement, et chaque partie en « U » s'étend essentiellement dans un plan vertical parallèle à l'axe d'enroulement ;
■ un matériau électriquement isolant est interposée entre les branches superposées des parties inférieure et supérieure pour les isoler électriquement l'une de l'autre ;
■ l'anneau comporte une seconde bobine enroulée autour d'un second axe vertical d'enroulement, les spires de cette seconde bobine étant formées par des pistes conductrices, réalisées dans les couches de métallisation, raccordées électriquement les unes aux autres par des plots traversant au moins l'une des couches électriquement isolante ; le second trou s'étend le long du second axe d'enroulement, et les première et seconde bobines comportent :
   - une même première piste conductrice, réalisée dans une première couche de métallisation, enroulée dans un sens autour du premier axe vertical d'enroulement et enroulée, en sens opposé, autour du second axe vertical d'enroulement,
   - une même deuxième piste conductrice, réalisée dans une seconde couche de métallisation, enroulée dans un sens autour du premier axe vertical d'enroulement et enroulée, en sens opposé, autour du second axe vertical d'enroulement, et
   - un premier plot traversant au moins l'une des couches isolantes pour raccorder électriquement les première et deuxième pistes conductrices l'une à l'autre de manière à ce que, lorsqu'elles sont alimentées, le courant tourne dans un sens dans la première bobine et dans le sens opposé dans la seconde bobine ;
■ la superposition, dans un plan parallèle aux couches de métallisation, des pistes conductrices des première et seconde bobines, réalisées dans une première et une seconde couches de métallisation, forme un motif présentant deux symétries axiales par rapport à des axes X et Y, ces axes X et Y étant orthogonaux entre eux et parallèles aux couches de métallisation, la ou les pistes conductrices de chacune des couches de métallisation superposées étant dépourvues, à elles seules, de symétrie axiale par rapport à l'axe X ou Y.

Ces modes de réalisation de l'anneau magnétique bobiné présentent en outre les avantages suivants :
- la présence d'un jeu important, c'est-à-dire supérieur à 5µm ou 100µm, permet d'éviter de contraindre mécaniquement l'anneau magnétique lors de son assemblage,
- utiliser des parties en « U » qui s'étendent essentiellement dans un plan vertical limite les contraintes mécaniques, telles que le pliage, exercées sur ce matériau magnétique lors de la fabrication de l'anneau magnétique bobiné,
- la présence d'une lame de matériau électriquement isolant entre les branches des parties en « U » qui se superposent permet de décroître les pertes par courant de Foucault dans cet anneau magnétique bobiné ;
- réaliser les spires de chaque bobinage à l'aide d'une même piste conductrice permet de réduire le nombre de vias et facilite donc la fabrication ;
- l'agencement des pistes conductrices pour qu'elles définissent un motif ayant des symétries axiales lorsque ces pistes conductrices sont superposées dans un même plan accroît l'homogénéité du champ magnétique généré par ces bobines et diminue le biais par rapport à des bobines conventionnelles réalisées sans précaution particulière.

L'invention sera mieux comprise à la lecture de la description qui va suivre, donnée uniquement à titre d'exemple non limitatif et faite en se référant aux dessins sur lesquels :
- la figure 1 est une illustration schématique et en perspective d'un capteur de champ magnétique,
- les figures 2 à 5 sont des illustrations des pistes conductrices gravées dans différentes couches de métallisation pour réaliser des bobines du capteur de la figure 1,
- la figure 6 est une illustration de la superposition, dans un plan, des pistes conductrices illustrées dans les figures 3 et 4
- les figures 7 et 8 sont des illustrations schématiques et en perspective d'un anneau magnétique bobiné utilisé dans le capteur de la figure 1, dans des vues, respectivement, éclatée et assemblée,
- la figure 9 est une illustration schématique d'un détail de l'anneau magnétique bobiné des figures 7 et 8,
- la figure 10 est une illustration schématique et en perspective d'un générateur de tension alternative, et
- la figure 11 est une illustration en vue de dessus de pistes conductrices d'un circuit imprimé du générateur de la figure 10.

Dans ces figures, les mêmes références sont utilisées pour désigner les mêmes éléments.

Dans la suite de cette description, les caractéristiques et fonctions bien connues de l'homme du métier ne sont pas décrites en détail.

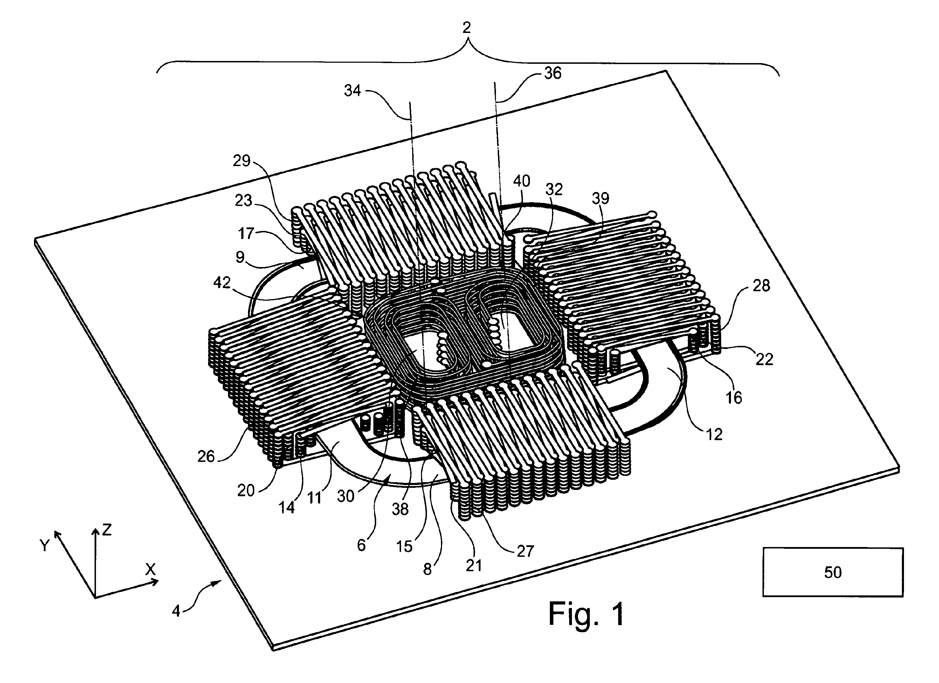

La figure 1 représente un capteur 2 à vanne de flux également appelé capteur fluxgate. Ce capteur 2 est capable de mesurer l'orientation et, éventuellement, l'intensité d'un champ magnétique extérieur T. Plus précisément, le capteur 2 mesure les composantes T_{X}, T_{Y} et T_{Z} correspondant, respectivement, aux projections du champ magnétique T sur trois directions non colinéaires X, Y et Z. Ici, les directions X, Y et Z sont orthogonales entre elles. La direction Z est la direction verticale et les directions X et Y définissent un plan horizontal.

Des capteurs à vanne de flux sont bien connus. On pourra par exemple se référer à la demande de brevet US 7 372 261 pour leur fonctionnement. Par conséquent, dans cette description, seuls les éléments nécessaires à la compréhension de l'invention sont décrits en détail.

Le capteur 2 comprend un circuit imprimé 4 multicouche. Typiquement, le circuit imprimé 4 comprend plus de deux ou cinq couches de métallisation et de préférence plus de dix couches de métallisation. Ici il comporte dix couches de métallisation. Pour simplifier la figure 1, seule une couche du circuit 4 a été illustrée. Les couches de métallisation sont empilées les unes au-dessus des autres dans la direction Z. La couche de métallisation la plus en haut dans la direction Z correspond à la face supérieure tandis que la couche de métallisation la plus en bas correspond à la face inférieure du circuit imprimé.

Le circuit imprimé 4 comprend un anneau magnétique 6 logé dans une cavité annulaire horizontale. L'anneau 6 est situé entre les faces supérieure et inférieure du circuit imprimé. Il est typiquement réalisé dans un matériau magnétique dont la perméabilité relative statique, c'est-à-dire à fréquence nulle, est supérieure à 1 000 et de préférence supérieure à 10 000. Par exemple, le matériau magnétique est un mumétal ou un matériau magnétique connu sous le nom commercial de Vitrovac® 6025.

Ici, l'anneau 6 est fabriqué indépendamment du circuit imprimé 4 puis inséré dans la cavité pendant la fabrication du circuit imprimé. A cet effet, les dimensions transversales de l'anneau 6, c'est-à-dire dans ce cas les dimensions de l'anneau dans un plan vertical, sont plus petites d'au moins 5 µm et, de préférence, d'au moins 100 µm par rapport aux dimensions transversales correspondantes de la cavité. Par conséquent, il existe un jeu entre les parois de la cavité et les faces en vis-à-vis de l'anneau 6. Grâce à ce jeu, l'anneau magnétique n'est pas mécaniquement contraint par le circuit imprimé 4. Ceci permet d'accroître notablement la précision du capteur 2 car toute contrainte mécanique exercée sur l'anneau 6 modifie ses propriétés magnétiques par magnétostriction et engendre donc des perturbations du champ magnétique T mesuré.

Ici, l'anneau 6 comprend deux barreaux 8 et 9 parallèles à la direction X et deux barreaux magnétiques 11 et 12 parallèles à la direction Y. Les extrémités de ces barreaux sont reliées les unes aux autres par un angle en matériau magnétique pour former l'anneau 6.

Pour saturer l'anneau magnétique 6, quatre bobines d'excitation 14 à 17 sont réalisées dans le circuit imprimé 4. Ces bobines d'excitation sont parcourues par un même courant d'excitation i_{exH} à une fréquence d'excitation f_{exH}. Typiquement, la fréquence d'excitation f_{exH} est supérieure à 300 Hz et, de préférence, supérieure à 10 kHz. Ici, les bobines 14 à 17 sont enroulées autour, respectivement, des barreaux 11, 8, 12 et 9.

Les bobines 14 à 17 sont raccordées en série les unes aux autres de manière à générer un champ magnétique d'excitation B_{exH} de même sens quand elles sont parcourues par le courant i_{exH}. Chaque bobine 14 à 17 est formée par des pistes conductrices réalisées dans deux couches de métallisation du circuit imprimé situées, respectivement, au-dessus et en dessous de l'anneau magnétique 6. Les extrémités de ces pistes conductrices sont raccordées entre elles par des vias verticaux pour former les spires des bobines 14 à 17. Un tel mode de réalisation de bobines s'étendant le long d'un axe horizontal est, par exemple, décrit dans la demande de brevet WO 2008/016198.

Le circuit imprimé 4 comporte également quatre bobines de mesure 20 à 23 enroulées, respectivement, autour des barreaux 11, 8, 12 et 9 pour mesurer le champ magnétique à l'intérieur de ces barreaux. Les mesures du champ magnétique réalisées par chacune de ces bobines 20 à 23 sont notées, respectivement, M₁, M₂, M₃ et M₄. Ici, ces mesures sont données par les relations suivantes :
- M₁ = T_{Y} - Be_{xH},
- M₂ = **T_{X}** + B_{exH},
- M₃ = T_{Y} + B_{exH}, et
- M₄ = T_{X} - B_{exH}.

Ces relations sont données avec les conventions suivantes :
- le champ magnétique d'excitation B_{exH} tourne dans le sens antihoraire, et
- les composantes T_{X} et T_{Y} sont dirigées dans la même direction que dans les directions X, Y respectivement.

Ici, les bobines 20 à 23 sont enroulées autour des bobines d'excitation, respectivement, 14 à 17. Ces bobines 20 à 23 sont formées par des pistes conductrices réalisées dans des couches de métallisation situées au-dessus et en dessous de celles utilisées pour réaliser les pistes conductrices des bobines d'excitation.

Dans ce mode de réalisation, quatre bobines de compensation 26 à 29 sont également enroulées, respectivement, autour des bobines de mesure 20 à 23 pour annuler le champ magnétique dans les barreaux, respectivement, 11, 8, 12 et 9. Dans ces conditions, la mesure des composantes T_{X} et T_{Y} se déduit de l'intensité du courant i_{cH} de compensation qui circule dans ces bobines 26 à 29.

Ces bobines 26 à 29 sont formées par des pistes conductrices réalisées dans des couches de métallisation situées au-dessus et en dessous de celles utilisées pour former les pistes conductrices des bobines de mesure.

Du fait que l'on travaille ici en champ magnétique nul, cela diminue le couplage magnétique entre les mesures réalisées selon les directions X et Y qui pourrait apparaître autrement.

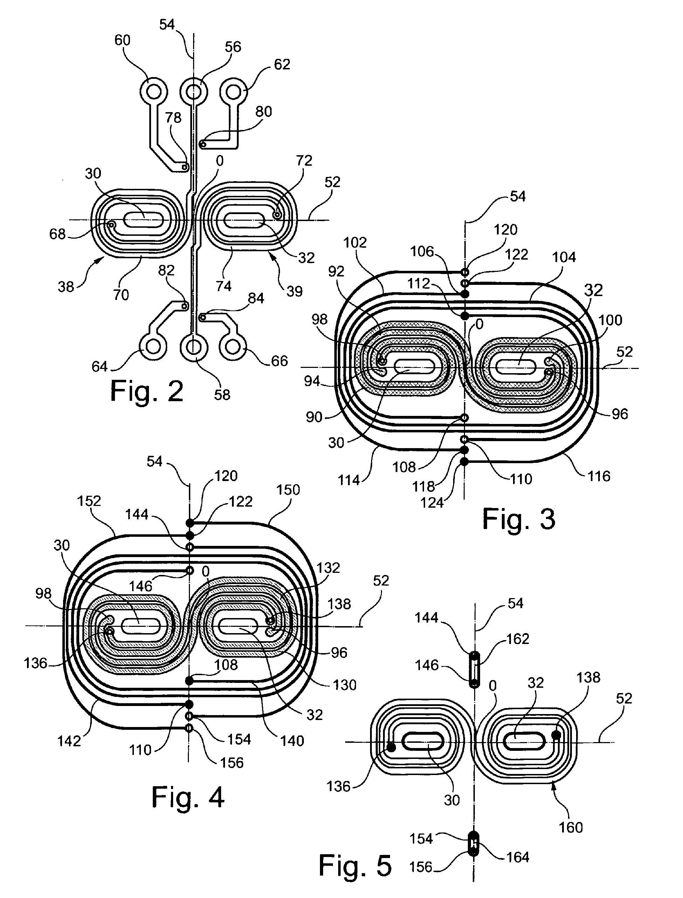

Le circuit imprimé 4 comprend aussi des bobines verticales pour mesurer la composante T_{Z}. Par bobine verticale, on désigne des bobines qui s'enroulent et s'étendent le long d'un axe vertical. Ces bobines sont décrites en détail en référence aux figures 2 à 5. Sur la figure 1, elles ne sont qu'illustrées très schématiquement.

Plus précisément, deux trous 30 et 32 traversent de part en part le circuit imprimé 4 le long, respectivement, d'axes verticaux 34 et 36. Ces trous 30 et 32 sont destinés à recevoir chacun une branche respective d'un anneau magnétique vertical. Cet anneau magnétique vertical n'a pas été représenté sur la figure 1 pour simplifier l'illustration.

Autour de ces trous 30 et 32, le circuit imprimé comprend deux bobines 38 et 39 d'excitation propres à générer un champ magnétique d'excitation Bₑₓᵥ capable de saturer l'anneau magnétique vertical lorsqu'elles sont parcourues par un courant d'excitation iₑₓᵥ de fréquence fₑₓᵥ. Par exemple, le courant iₑₓᵥ et la fréquence fₑₓᵥ sont pris égaux, respectivement, au courant i_{exH} et à la fréquence f_{exH}.

Une bobine verticale de mesure 40 entoure les deux trous 30 et 32. Cette bobine 40 est destinée à mesurer le champ magnétique dans l'anneau magnétique vertical.

Enfin, une bobine verticale de compensation 42 est également réalisée dans le circuit imprimé 4. Cette bobine entoure les trous 30 et 32. Comme précédemment, cette bobine a pour fonction d'annuler le champ magnétique dans l'anneau magnétique vertical lorsqu'elle est parcourue par un courant i_{cv} de compensation.

Les spires de ces bobines 38, 39, 40 et 42 sont formées par des pistes conductrices réalisées dans des couches de métallisation du circuit imprimé 4. Ces pistes conductrices sont raccordées les unes aux autres par l'intermédiaire de vias verticaux pour raccorder électriquement les spires d'une même bobine entre elles.

Enfin, le capteur 2 comporte une unité électronique 50 de traitement apte à commander l'alimentation des bobines d'excitation et de compensation et à traiter les signaux des bobines de mesure pour obtenir une mesure du champ magnétique T. Typiquement, la mesure de chaque composante du champ magnétique T est obtenue à partir de l'amplitude d'une harmonique de la fréquence d'excitation dans la tension recueillie aux bornes des bobines de mesure. Les connexions électriques entre l'unité 50 et les bobines n'ont pas été représentées pour simplifier la figure.

Ces bobines 38, 39, 40 et 42 vont maintenant être décrites plus en détail en référence aux figures 2 à 6.

Les figures 2 à 5 représentent les pistes conductrices réalisées, respectivement, dans une couche de métallisation supérieure, dans une couche de métallisation intermédiaire paire, dans une couche de métallisation intermédiaire impaire et dans une couche de métallisation inférieure. La couche de métallisation supérieure contient les pistes conductrices qui forment l'extrémité supérieure des bobines 38 à 40 et 42. La couche de métallisation inférieure contient les pistes conductrices qui forment les extrémités inférieures des bobines 38 à 40 et 42.

Les couches de métallisation intermédiaires sont situées entre les couches de métallisation supérieure et inférieure. Elles contiennent les pistes conductrices qui forment l'essentiel des spires de chaque bobine. Ici, les couches de métallisation intermédiaire sont empilées les unes au-dessus des autres en alternant une couche de métallisation paire et une couche de métallisation impaire. Les couches de métallisation paires sont toutes identiques entre elles de sorte qu'une seule de ces couches de métallisation paires sera décrite. De façon similaire, les couches de métallisation impaires sont toutes identiques entre elles et une seule de ces couches de métallisation impaires est décrite en détail en référence à la figure 4. Le nombre de couches de métallisation intermédiaires est supérieur à deux et, de préférence, supérieur à quatre ou huit.

Chacune de ces couches de métallisation est traversée par les trous 30 et 32. La section transversale de ces trous est identique dans chaque couche de métallisation. Ici, les trous 30 et 32 sont oblongs et s'étendent le long d'un même axe 52. L'axe 52 constitue également un axe de symétrie pour les trous 30, 32. Les trous 30 et 32 sont également symétriques par rapport à un autre axe 54 perpendiculaire à l'axe 52. Les axes 52 et 54 se coupent en un point O. Dans la suite de cette description, on désigne sous les mêmes références 52, 54 les mêmes axes de symétrie quelle que soit la couche de métallisation à laquelle ils appartiennent.

Dans ce mode de réalisation, chaque bobine 38, 39, 40 et 42 comprend un bobinage descendant et un bobinage montant. L'utilisation d'un bobinage descendant et d'un bobinage montant pour former une même bobine permet de réaliser les plots de connexion pour alimenter cette bobine sur une même face du circuit imprimé. Ici, ces plots de connexion sont réalisés sur la face supérieure.

Le bobinage descendant s'enroule autour du ou des trous 30, 32 en descendant de la face supérieure vers la face inférieure. A l'inverse, le bobinage montant s'enroule autour de ces mêmes trous en montant de la face inférieure vers la face supérieure. Les bobinages descendant et montant d'une même bobine sont raccordés en série pour que le courant qui les parcourt tourne toujours dans le même sens autour du ou des trous 30, 32.

Dans la suite de cette description, le terme « raccordé » désigne un raccordement électrique.

Les bobines 38 et 39 s'enroulent, en sens opposé, respectivement autour des trous 30 et 32. Les bobines 40 et 42 s'enroulent autour des bobines 38 et 39 et donc autour des trous 30 et 32. La bobine 42 s'enroule autour de la bobine 40.

Sur ces figures 2 à 5, un cercle situé à l'extrémité d'une piste conductrice représente un via descendant qui raccorde cette piste conductrice à une piste conductrice d'une couche de métallisation juste en dessous. A l'inverse, un point plein situé à l'extrémité d'une piste conductrice représente l'extrémité d'un via montant qui raccorde cette piste conductrice à une piste conductrice de la couche de métallisation juste au-dessus. Ainsi, le cercle correspond à l'extrémité supérieure d'un via tandis que le point correspond à l'extrémité inférieure de ce même via.

La figure 2 représente des plots 56 et 58 de connexion pour alimenter les bobines 38 et 39. Ces plots sont tous les deux situés sur l'axe 54 de part et d'autre de l'axe 52.

La couche de métallisation supérieure comporte également des plots 60 et 62 de connexion entre lesquels la bobine de mesure 40 génère une tension représentative du champ magnétique présent à l'intérieur de l'anneau magnétique vertical.

Cette couche de métallisation supérieure comprend aussi des plots 64 et 66 de connexion pour alimenter la bobine de compensation 42.

Le plot 56 est raccordé à un via descendant 68 par une piste conductrice 70. La piste conductrice 70 s'enroule dans le sens horaire en allant de l'extérieur vers l'intérieur autour du trou 30. Ici, cette piste 70 fait plusieurs tours complets avant d'atteindre le via 68.

Le plot 58 est raccordé à un via descendant 72 par une piste conductrice 74. La piste conductrice 74 est le symétrique de la piste conductrice 70 par une symétrie centrale par rapport au point O.

Les plots 60, 62, 64 et 66 sont raccordés, respectivement, à des vias descendants 78, 80, 82 et 84.

La figure 3 représente une couche de métallisation paire. Dans cette couche de métallisation, les spires des bobinages descendants des bobines 38 et 39 sont formées à l'aide d'une seule piste conductrice 90. De façon similaire, les spires des bobinages montants des bobines 38 et 39 sont formées à l'aide d'une seule piste conductrice 92. La piste conductrice 90 :
- s'enroule autour du trou 30 à partir d'un via montant 94 dans le sens horaire en allant de l'intérieur vers l'extérieur, puis
- s'enroule autour du trou 32 jusqu'à un via descendant 96 dans le sens antihoraire en allant de l'extérieur vers l'intérieur.

La piste conductrice 92 s'étend, à écartement constant, le long de la piste conductrice 90. Ainsi, la piste conductrice 92 :
- s'enroule à partir d'un via descendant 98 autour du trou 30 dans le sens horaire en allant de l'intérieur vers l'extérieur, puis
- s'enroule autour du trou 32 jusqu'à un via montant 100 dans le sens anti-horaire en allant de l'extérieur vers l'intérieur.

Ici, les pistes 92 et 94 font plusieurs tours chacune autour des trous 30 et 32.

Dans cette couche de métallisation, les spires des bobinages descendant et montant de la bobine 40 sont formées par seulement deux pistes conductrices, respectivement, 102 et 104. La piste 102 s'enroule à partir d'un via montant 106 autour des pistes conductrices 90 et 92 jusqu'à un via descendant 108 dans le sens anti-horaire en allant de l'extérieur vers l'intérieur. La piste 104 s'enroule à partir d'un via descendant 110 autour des pistes 90 et 92 jusqu'à un via montant 112 dans le sens anti-horaire en allant de l'extérieur vers l'intérieur. Les pistes 102 et 104 font plusieurs tours complets autour des trous 30 et 32.

Les spires des bobinages descendant et montant de la bobine 42 sont formées par seulement deux pistes conductrices, respectivement, 114 et 116. Les pistes 114 et 116 s'enroulent autour des pistes 102 et 104. Plus précisément, la piste 114 s'enroule à partir d'un via montant 118 vers un via descendant 120 en tournant dans le sens horaire. La piste 116 s'enroule autour des pistes 102 et 104 à partir d'un via montant 124 vers un via descendant 122 en tournant dans le sens anti-horaire. Dans cet exemple, les pistes 114 et 116 forment chacune uniquement un demi-tour dans cette couche de métallisation.

Les vias 106, 108, 110, 112, 118, 120 et 124 sont tous alignés sur l'axe 54.

Les pistes conductrices des bobinages montant et descendant de chaque bobine dans cette couche de métallisation présentent une symétrie centrale par rapport au point O mais aucune symétrie axiale.

La figure 4 représente les pistes conductrices réalisées dans la couche de métallisation impaire située juste en dessous de la couche de métallisation de la figure 3. Par conséquent, on retrouve dans cette figure les extrémités des vias descendants de la figure précédente. Ces extrémités portent donc les mêmes références.

Les spires des bobinages descendants et montants des bobines 38 et 39 sont formées par seulement deux pistes conductrices 130 et 132. La piste conductrice 130 s'étend du via 96 vers un via descendant 136. La piste 132 s'étend du via 98 vers un via descendant 138.

Les spires des bobinages descendant et montant de la bobine 40 sont formées par seulement deux pistes conductrices 140 et 142. La piste 140 s'étend du via 108 vers un via descendant 144. La piste 142 s'étend du via 110 vers un via descendant 146.

Enfin, les spires des bobinages descendant et montant de la bobine 42 sont formées par seulement deux pistes conductrices 150 et 152. La piste 150 s'étend du via 120 jusqu'à un via descendant 154 et la piste 152 s'étend du via 122 jusqu'à un via descendant 156.

Les pistes 130, 132, 140, 142, 150 et 152 se déduisent, respectivement, des pistes 92, 90, 104, 102, 116 et 114 par une symétrie axiale par rapport à l'axe 52. Les pistes 130, 132, 140, 142, 150 et 152 se déduisent également, respectivement, des pistes 90, 92, 102, 104, 114 et 116 par une symétrie axiale par rapport à l'axe 54. Ainsi, la structure de ces pistes n'est pas décrite ici plus en détail. On remarquera aussi que comme dans le cas de la figure 3, les pistes de chaque bobine présente une symétrie centrale par rapport au point O mais aucune symétrie axiale.

Les vias 108, 110, 120, 122, 144, 146, 154 et 156 sont alignés sur l'axe 54.

La figure 5 représente la couche de métallisation inférieure qui comporte des pistes conductrices pour raccorder les bobinages descendants et montants de chaque bobine entre eux. Ici, ces bobinages descendants et montants sont raccordés entre eux de manière à ce que le courant qui les traverse tourne dans le même sens quand ils sont alimentés. Pour simplifier la description, on suppose que cette couche de métallisation est juste en dessous de la couche de métallisation impaire de la figure 4. Par conséquent, on retrouve dans cette figure les extrémités inférieures des vias descendants précédemment décrits.

Les bobines 38 et 39 comprennent une piste conductrice 160 qui, en partant du via 136, s'enroulent autour du trou 30 en sens horaire en allant de l'intérieur vers l'extérieur, puis s'enroule autour du trou 32 jusqu'au via 138 dans le sens anti-horaire en allant de l'extérieur vers l'intérieur. Cette piste 160 présente une symétrie centrale par rapport au point O. La piste 160 fait plusieurs tours complets autours des trous 30,32.

Une piste conductrice 162 raccorde les vias 144 et 146 de la bobine de mesure 40. Une piste conductrice 164 raccorde les vias 154 et 156 de la bobine de compensation 42.

Les pistes 90, 92 ou 130, 132 d'une couche de métallisation intermédiaire ne peuvent pas présenter à elles seules une symétrie axiale car elles s'enroulent en sens opposé autour des trous 30 et 32.

L'ensemble des deux pistes conductrices 102, 104 ou l'ensemble des deux pistes conductrices 140, 142 ne peut pas présenter, non plus, de symétrie axiale dans une couche de métallisation intermédiaire. En effet, les pistes des bobinages descendant et montant sont réalisées dans la même couche de métallisation, ce qui impose de les décaler les unes par rapport aux autres. Cette remarque vaut également pour les pistes 90, 92 ; 130, 132 ; 114, 116 et 150, 152.

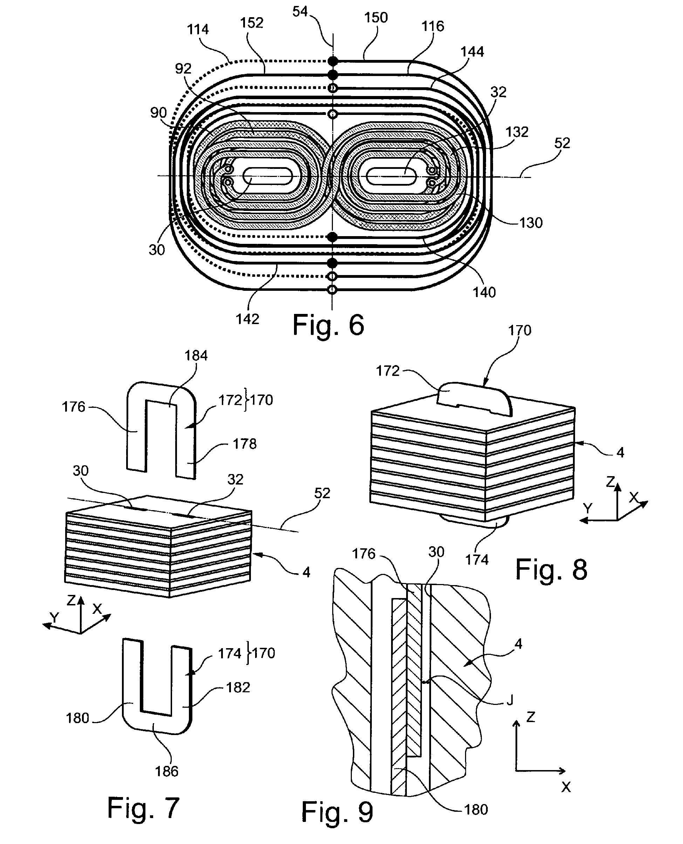

Or, l'un des objectifs des bobines conçues est d'augmenter leur symétrie de manière à améliorer l'homogénéité du champ magnétique le long de leurs axes d'enroulement respectifs et à limiter les biais observés par rapport à des bobines idéales. Pour cela, l'agencement décrit ici des pistes conductrices de chaque couche de métallisation paire et impaire fait apparaître de nouveaux axes de symétrie lorsque ces pistes conductrices sont superposées dans un plan horizontal. La superposition des couches de métallisation paire et impaire a été représentée dans la figure 6. Cette superposition fait apparaître deux symétries axiales, respectivement, par rapport aux axes 52 et 54. Cela permet de réduire le biais par rapport à des bobinages filaires et d'augmenter l'homogénéité du champ magnétique le long de l'axe d'enroulement. Quand les pistes de la couche de métallisation paire et impaire se superposent, seule l'une des pistes est visible sur la figure 6.

Enfin, dans le cas particulier décrit ici, la couche de métallisation paire située juste en dessous de la couche de métallisation supérieure ne présente pas de symétrie axiale parfaite quand on la superpose avec une couche de métallisation impaire. En effet, dans cette couche de métallisation paire, les vias 106, 112, 118 et 124 sont légèrement décalés par rapport à l'axe 54 pour correspondre aux extrémités des vias, respectivement, 80, 78, 84 et 82. Toutefois, à l'exception de cette couche de métallisation paire, toutes les autres couches de métallisation intermédiaires paire présentent deux symétries axiales parfaites quand on les superpose avec l'une quelconque des couches de métallisation impaire.

Les figures 7 et 8 représentent un anneau magnétique bobiné utilisé dans le capteur 2 pour réaliser la mesure de la composante T_{z}. Sur ces figures, les autres parties du capteur 2 n'ont pas été représentées. Plus précisément, cet anneau magnétique bobiné comprend un anneau magnétique 170 logé dans les trous 30 et 32 du circuit imprimé 4. La figure 7 est une vue éclatée de l'anneau magnétique bobiné tandis que la figure 8 est une vue assemblée de ce même anneau magnétique bobiné. L'anneau magnétique 170 est formé d'une partie supérieure 172 en « U » et d'une partie inférieure 174 en « U ». Les parties inférieure et supérieure présentent chacune deux branches verticales, respectivement, 176, 178 et 180, 182 reliées par un jambage horizontal, respectivement, 184 et 186 qui forme le fond des « U ».

Les parties 172 et 174 sont découpées dans une plaque en matériau magnétique dont la perméabilité relative statique est supérieure à 1 000 et de préférence supérieure à 10 000. Par exemple, le matériau magnétique est un mumétal ou un matériau magnétique connu sous le nom commercial de Vitrovac® 6025. Ainsi, leur fabrication limite les contraintes mécaniques appliquées au matériau magnétique. En particulier, cela permet d'éviter de plier le matériau magnétique pour former le « U ». Les parties 172, 174 s'étendent essentiellement dans un plan vertical YZ passant par l'axe 52. La largeur de chacune de ces parties 172, 174 est dans ce plan vertical. L'épaisseur des parties 172 et 174 est perpendiculaire à ce plan vertical. L'épaisseur est typiquement inférieure à 250 µm et, de préférence, inférieure à 100 µm ou 25 µm.

Les branches 176, 178 sont introduites dans les trous, respectivement, 30 et 32 à partir de la face supérieure du circuit imprimé 4. A l'inverse, les branches 180 et 182 sont introduites dans les trous, respectivement, 30 et 32 à partir de la face inférieure.

Comme illustré sur la figure 9, dans ce cas particulier, les branches 176 et 180 se superposent l'une au-dessus de l'autre, dans la direction X, à l'intérieur du trou 30 pour assurer la continuité magnétique. Par exemple, les branches 176 et 180 se superposent sur plus d'un tiers de leur longueur verticale. Les branches 178, 182 se superposent de façon similaire à l'intérieur du trou 32.

Les dimensions transversales des branches sont plus petites d'au moins 5 µm et, de préférence, d'au moins 100 µm par rapport aux dimensions transversales correspondantes des trous pour ménager un jeu entre les parois verticales du trou et les faces en vis-à-vis des branches. Plus précisément, les dimensions transversales des branches sont choisies pour qu'un jeu J supérieur à 5 µm apparaisse entre la partie la plus épaisse de l'anneau magnétique 170 et les parois verticales du trou. La partie la plus épaisse de l'anneau 170 est l'endroit où les branches se superposent l'une au-dessus de l'autre dans la direction X. Grâce à la présence de ce jeu, l'anneau magnétique 170 n'est pas contraint mécaniquement, ce qui permet d'augmenter la précision du capteur 2.

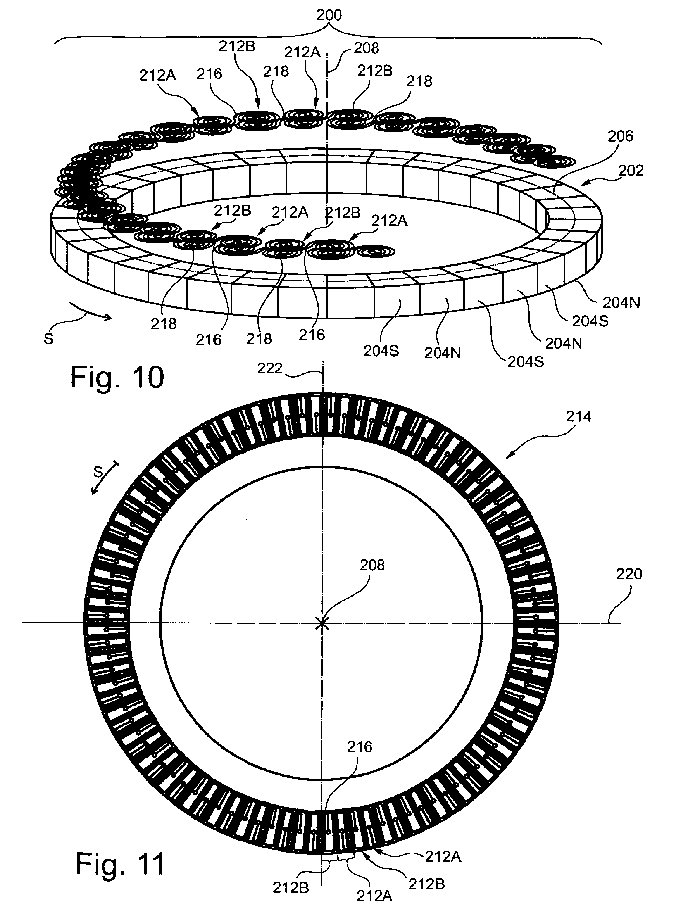

La figure 10 représente un générateur 200 d'une tension alternative à partir du déplacement d'un anneau aimanté 202. Ici, seuls les éléments nécessaires pour comprendre l'invention sont représentés. Ainsi, par exemple, les éléments qui déplacent l'anneau aimanté ou l'électronique de commande de ce générateur n'ont pas été représentés.

L'anneau 202 comprend une succession d'aimants 204 de polarité opposée disposés les uns à côté des autres le long d'une trajectoire 206. Ici, la trajectoire 206 est un cercle horizontal centré sur un axe de rotation vertical 208. Les aimants dont le pôle nord est tourné vers le haut portent la référence 204N. Les aimants dont le pôle sud est tourné vers le haut portent la référence 204S.

Les aimants 204 sont disposés le long de toute la trajectoire 206 en alternant les aimants 204N et 204S. Ici, un aimant 204S est introduit entre chaque aimant 204N. Par exemple, plus de dix aimants 204 sont disposés le long de la trajectoire 206.

Le générateur comprend également une succession de bobines 212 aptes à transformer le flux magnétique généré par chaque aimant 204 en une tension. Ces bobines 212 sont disposées pour cela en vis-à-vis de la succession d'aimants 204. Les bobines 212 sont disposées les unes à côté des autres le long de la trajectoire 206. Elles sont toutes identiques sauf qu'elles sont enroulées tantôt dans un sens et tantôt dans l'autre sens autour de leur axe vertical d'enroulement respectif. Les bobines 212 enroulées dans le sens horaire en partant de l'extérieur vers l'intérieur sont notées 212A. Les bobines 212 enroulées en sens inverse sont notées 212B. Les bobines 212A et 212B sont disposées en alternance le long de la trajectoire 206. Ici une bobine 212B est située entre chaque bobine 212A.

Les dimensions transversales des bobines 212 sont telles que quand une bobine 212A est en vis-à-vis d'un aimant 204N, les bobines 212B immédiatement adjacentes en amont et en aval se trouvent en vis-à-vis, respectivement, des aimants 204S immédiatement en amont et en aval de cet aimant 204N. De façon similaire, quand la bobine 212A est en vis-à-vis de l'aimant 204S, les bobines 212B immédiatement adjacentes en amont et en aval se trouvent en vis-à-vis, respectivement, des aimants 204N immédiatement en amont et en aval de cet aimant 204S. L'aval et l'amont sont ici définis par rapport à une direction S de rotation des aimants 204 par rapport aux bobines 212 autour de l'axe 208. Ainsi, quand une bobine 212 est en vis-à-vis d'un aimant 204, elle est essentiellement sensible au flux magnétique de cet aimant et non pas au flux magnétique des aimants adjacents.

Chaque bobine est formée par des pistes conductrices d'un circuit imprimé multicouche 214, ici deux couches (figure 11), raccordées entre elles par des vias verticaux. Sur la figure 10, le circuit imprimé 214 n'a pas été représenté pour simplifier cette illustration.

Ici, ces pistes conductrices sont réparties entre une couche de métallisation supérieure et une couche de métallisation inférieure.

Pour diminuer le nombre de vias verticaux utilisés, les bobines 212 sont regroupées en paires. Chaque paire comprend une bobine 212A et une bobine 212B immédiatement adjacente dans la direction S. Dans chaque paire, la bobine 212B est en amont de la bobine 212A.

Dans la couche de métallisation supérieure, les spires des bobines 212A et 212B d'une même paire sont formées à l'aide d'une seule piste conductrice 216. La piste 216 :
- s'enroule autour de l'axe d'enroulement de la bobine 212B, à partir d'un via descendant, dans le sens antihoraire en allant de l'intérieur vers l'extérieur, puis
- s'enroule autour de l'axe d'enroulement de la bobine 212A en allant dans le sens horaire de l'extérieur vers l'intérieur jusqu'à un autre via montant.

Ici, la piste 216 fait plusieurs tours complets autour de chaque axe d'enroulement. Par exemple la piste 216 est identique à la piste 90 précédemment décrite.

Les spires de la bobine 212B dans la couche de métallisation inférieure sont formées par une piste conductrice 218. La piste 218 s'enroule autour de l'axe d'enroulement de la bobine 212B dans le sens horaire en allant de l'extérieur vers l'intérieur jusqu'à l'extrémité inférieure du via montant. La piste 218 s'enroule également autour de l'axe d'enroulement de la bobine 212A de la paire immédiatement en amont dans le sens horaire en allant de l'extérieur vers l'intérieur.

Les spires dans la couche de métallisation inférieure de la bobine 212A de cette paire sont formées par la piste conductrice 218 qui forme également les spires de la bobine 212B de la paire immédiatement en aval.

Ainsi, la piste 218 forme à la fois les spires des bobines 212A et 212B de deux paires adjacentes. Elle raccorde également en série les bobines de ces paires adjacentes de manière à ce que le courant qui circule dans les spires d'une bobine 212 tourne toujours dans le même sens aussi bien dans la couche de métallisation supérieure qu'inférieure. Ce raccordement en série permet d'additionner les tensions générées par chacune des bobines lorsque celles-ci se trouvent en vis-à-vis d'un aimant 204. La piste 218 est similaire à la piste 130 précédemment décrite mais décalée d'un pas angulaire. Ce pas angulaire est égal à l'angle entre deux axes verticaux d'enroulement successifs des bobines 212 et le centre 208.

La figure 11 représente la couche de métallisation supérieure du circuit imprimé 214. Sur cette figure, les extrémités supérieures des vias sont représentées par des ronds. Ces extrémités supérieures sont toutes alignées sur un même cercle centré sur l'axe 208. Les pistes conductrices 216 de la couche de métallisation supérieure présente deux symétries axiales par rapport à des axes 220 et 222. Les axes 220 et 222 sont orthogonaux entre eux et contenus dans le plan de la couche de métallisation supérieure.

De plus, dans ce mode de réalisation, la superposition des pistes conductrices 216 et 218 dans un plan horizontal crée un motif qui présente une symétrie de révolution. Plus précisément, ce motif est invariant par une rotation d'un pas angulaire égal à la distance angulaire entre deux axes verticaux d'enroulement successifs des bobines 212.

Lors de son fonctionnement, lorsqu'une bobine 212A d'une paire de bobines se trouve en face d'un aimant 204N, elle génère une tension U. Dans le même temps, la bobine 212B de la même paire se trouve en face d'un aimant 204S et génère donc également une tension U. Le même phénomène se reproduit dans chaque paire de bobines 212. Etant donné que ces paires de bobines sont raccordées en série, les tensions 2U générées par chaque paire s'additionnent donc de manière à obtenir une tension beaucoup plus importante. Lorsque l'anneau aimanté 202 se déplace par rapport au circuit imprimé 214, la bobine 212A qui était précédemment en vis-à-vis de l'aimant 204N se trouve maintenant en vis-à-vis de l'aimant 204S suivant. Dans ces conditions, cette bobine 212A comme toutes les autres bobines génère une tension -U. Ainsi, en déplaçant en rotation le circuit imprimé 214 par rapport à l'anneau aimanté 202, une tension alternative est générée.

De nombreux autres modes de réalisation sont possibles. Par exemple, pour augmenter l'épaisseur du circuit imprimé, plusieurs circuits imprimés réalisés comme décrits précédemment peuvent être empilés les uns au-dessus des autres dans la direction verticale. Lors de cet empilement, ces circuits imprimés sont raccordés entre eux en préservant le sens d'enroulement des spires de chaque bobine. Superposer plusieurs circuits imprimés multicouches permet ainsi d'augmenter le rapport longueur/largeur des anneaux magnétiques, ainsi que le nombre de spires du capteur.

Les pistes conductrices peuvent être gravées dans la couche de métallisation ou déposées dans cette couche de métallisation.

Dans une variante simplifiée, une seule bobine d'excitation est utilisée pour générer le champ magnétique d'excitation dans l'ensemble de l'anneau magnétique.

Les pistes conductrices qui forment les différentes bobines peuvent ne faire qu'une demi-spire autour des trous 30 et 32 comme illustré dans le cas de la bobine 42 de compensation. Une demi-spire est un simple demi-tour autour de l'axe d'enroulement. Dans une autre variante, les bobinages montants sont omis.

Le circuit imprimé peut également comporter des couches de métallisation intermédiaires comportant des pistes conductrices qui, lorsqu'elles sont superposées dans un plan horizontal, ne font pas apparaître un motif présentant deux symétries axiales.

Les couches décrites en référence aux figures 2 et 5 peuvent être omises. Dans ce cas, les connexions électriques avec les bobines se font directement sur les couches intermédiaires.

Dans chaque couche intermédiaire, les pistes 96 et 98 peuvent être fusionnées. On obtient alors un bobinage uniquement descendant mais présentant une bonne symétrie.

En variante, c'est la superposition des pistes conductrices de plus de trois couches de métallisation qui fait apparaître un motif présentant deux symétries axiales.

Il n'est pas nécessaire que les couches de métallisation qui se superposent pour former un motif ayant des symétries axiales soient des couches de métallisation immédiatement successives dans l'empilement de couches de métallisation.

L'anneau magnétique vertical peut être remplacé par deux barreaux magnétiques parallèles. Contrairement à l'anneau magnétique, ces barreaux sont magnétiquement isolés l'un de l'autre par un entrefer important. Dans ce cas, les spires des bobines d'excitation sont enroulées dans le même sens, respectivement, autour des axes 34 et 36 de ces barreaux. Dans cette configuration aussi, les pistes conductrices des couches de métallisation paire et impaire sont agencées pour que leur superposition dans un plan horizontal fasse apparaître un motif avec deux symétries axiales.

L'enroulement spécifique des bobines d'excitation décrit ici peut aussi être mis en oeuvre pour réaliser des bobines d'excitations enroulées et s'étendant le long d'axes d'enroulement horizontaux et parallèles. Comme précédemment décrit, cela permet de limiter le nombre de vias verticaux situés entre les branches d'un anneau magnétique horizontale ou entre des barreaux magnétiques horizontaux parallèles et magnétiquement isolés l'un de l'autre.

La partie en « U » du noyau magnétique bobiné peut être obtenue en pliant un ruban ou un fil. Dans ce cas, de préférence, le ruban ou le fil est enroulé pour former une ou plusieurs spires traversant chacune les trous 30 et 32.

Plusieurs parties en « U » peuvent être insérées à l'intérieur des trous à partir de la même face du circuit imprimé de manière à augmenter l'épaisseur de l'anneau magnétique dans une direction horizontale.

Les branches verticales 176, 178 peuvent être logées à l'intérieur d'un guide rigide. Par exemple, le guide est réalisé dans un matériau ou une combinaison de matériaux présentant un module de Young à 25°C supérieur à 5 GPa et, de préférence, supérieur à 50 GPa. Le guide rigide permet de faciliter l'insertion des branches verticales dans les trous 30, 32. Dans ce cas, le jeu entre les branches verticales et ce guide correspond au jeu décrit ci-dessus entre les branches verticales et les parois des trous 30, 32. Le guide permet également de mieux positionner les éléments magnétiques. Le guide a typiquement une section transversale horizontale en forme de « U » pour recevoir chaque branche verticale.

En variante, un isolant diélectrique est inséré entre les branches des parties en « U » qui se superposent de manière à les isoler électriquement les unes des autres. Pour cela, il est possible de découper dans un matériau électriquement isolant une partie en « U » puis d'introduire cet isolant en « U » entre les parties en « U » inférieure et supérieure 172 et 174. Une autre possibilité consiste à vernir ou à introduire un liquide visqueux ou collant sur les faces extérieures des parties 172 et 174 qui se chevauchent. Une autre solution consiste encore à traiter la surface des branches pour la rendre électriquement isolante. Ce traitement est connu sous le terme de « passivation ».

L'une des branches verticales du « U » peut être logée à l'intérieur d'un trou qui n'est pas entouré par une bobine.

La trajectoire le long de laquelle sont disposés les aimants et les spires 212 n'est pas nécessairement circulaire. Par exemple, en variante, elle est rectiligne.

Les spires de la couche de métallisation inférieure du circuit imprimé du générateur de tension ne sont pas nécessairement identiques aux spires réalisées dans la couche de métallisation supérieure. Par exemple, le nombre de spires dans la couche de métallisation inférieure peut être plus petit ou plus grand que le nombre de spires dans la couche de métallisation supérieure.

Le circuit imprimé 114 peut comporter une ou plusieurs couches de métallisation dans lesquelles sont formées des spires supplémentaires.

## Revendications

1. Anneau magnétique bobiné, cet anneau comportant :
- un circuit imprimé (4) comportant :
• un empilement le long d'une direction verticale de plusieurs couches de métallisation séparées mécaniquement les unes des autres par des couches électriquement isolantes,
• au moins une première bobine (38) qui s'étend le long d'un premier axe vertical (34) d'enroulement, les spires de cette bobine étant formée par des pistes conductrices (90, 92, 130, 132), réalisées dans des couches de métallisation respectives, raccordées électriquement les unes aux autres par des plots traversant au moins l'une des couches électriquement isolantes,
• un premier et un second trous verticaux (30, 32) traversant de part en part le circuit imprimé, le premier trou (30) s'étendant le long du premier axe vertical (34),
- un anneau magnétique (170),
**caractérisé en ce que** l'anneau magnétique est formé d'une partie supérieure (172) en « U » et d'une partie inférieure (174) en « U », chaque partie supérieure et inférieure comportant deux branches verticales (176, 178, 180 , 182) introduites chacune dans un trou respectif du circuit imprimé, chaque branche de la partie supérieure se superposant, à l'intérieur du trou respectif et dans une direction horizontale, sur la branche correspondante de la partie inférieure pour établir la continuité magnétique entre ces deux parties de l'anneau magnétique.

2. Anneau selon la revendication 1, dans lequel les dimensions transversales, c'est-à-dire parallèlement au plan des couches de métallisation, de la superposition des branches verticales (176, 178, 180 , 182) sont plus petites d'au moins 5 µm que les dimensions transversales correspondantes des trous (30, 32) ou d'un guide rigide logé à l'intérieur de ces trous, pour ménager un jeu entre des parois verticales du trou ou du guide rigide et des faces verticales en vis-à-vis de l'anneau magnétique.

3. Anneau selon l'une quelconque des revendications précédentes, dans lequel :
- les trous (30, 32) sont oblongs et s'étendent le long d'un même axe horizontal d'alignement, et
- chaque partie (172, 174) en « U » s'étend essentiellement dans un plan vertical parallèle à l'axe d'enroulement.

4. Anneau selon l'une quelconque des revendications précédentes, dans lequel un matériau électriquement isolant est interposée entre les branches superposées des parties inférieure et supérieure pour les isoler électriquement l'une de l'autre.

5. Anneau selon l'une quelconque des revendications précédentes, dans lequel
- l'anneau comporte une seconde bobine (39) enroulée autour d'un second axe vertical (36) d'enroulement, les spires de cette seconde bobine étant formées par des pistes conductrices, réalisées dans les couches de métallisation, raccordées électriquement les unes aux autres par des plots traversant au moins l'une des couches électriquement isolante,
- le second trou (32) s'étend le long du second axe (36) d'enroulement, et
- les première et seconde bobines comportent :
• une même première piste conductrice (90), réalisée dans une première couche de métallisation, enroulée dans un sens autour du premier axe vertical (34) d'enroulement et enroulée, en sens opposé, autour du second axe vertical (36) d'enroulement,
• une même deuxième piste conductrice (130), réalisée dans une seconde couche de métallisation, enroulée dans un sens autour du premier axe vertical (34) d'enroulement et enroulée, en sens opposé, autour du second axe vertical (36) d'enroulement, et
• un premier plot (96) traversant au moins l'une des couches isolantes pour raccorder électriquement les première et deuxième pistes conductrices l'une à l'autre de manière à ce que, lorsqu'elles sont alimentées, le courant tourne dans un sens dans la première bobine et dans le sens opposé dans la seconde bobine.

6. Anneau selon la revendication 5, dans lequel la superposition, dans un plan parallèle aux couches de métallisation, des pistes conductrices (90, 92, 130, 132) des première et seconde bobines (38, 39), réalisées dans une première et une seconde couches de métallisation, forme un motif présentant deux symétries axiales par rapport à des axes X et Y, ces axes X et Y étant orthogonaux entre eux et parallèles aux couches de métallisation, la ou les pistes conductrices de chacune des couches de métallisation superposées étant dépourvues, à elles seules, de symétrie axiale par rapport à l'axe X ou Y.

## Patentansprüche

1. Gewickelter Magnetring, wobei dieser Ring umfasst:
- eine gedruckte Schaltung (4), umfassend:
• eine Stapelung mehrere mechanisch voneinander durch elektrisch isolierende Schichten getrennte Metallisierungsschichten entlang einer Vertikalrichtung,
• mindestens eine erste Spule (38), die sich entlang einer ersten vertikalen Wickelachse (34) erstreckt, wobei die Windungen dieser Spule von leitenden Spuren (90, 92, 130, 132) gebildet sind, die in jeweiligen Metallisierungsschichten ausgeführt sind, die elektrisch aneinander durch Stifte, die durch mindestens eine der elektrisch isolierenden Schichten hindurchgehen, angeschlossen sind,
• ein erstes und ein zweites vertikales Loch (30, 32), die durch die gedruckte Schaltung hindurchgehen, wobei sich das erste Loch (30) entlang der ersten Vertikalachse (34) erstreckt,
- einen Magnetring (170),
**dadurch gekennzeichnet, dass** der Magnetring von einem oberen "U-förmigen" Teil (172) und einem unteren "U-förmigen" Teil (174) gebildet ist, wobei jeder obere und untere Teil zwei vertikale Abschnitte (176, 178, 180, 182) umfasst, die jeweils in ein jeweiliges Loch der gedruckten Schaltung eingeführt sind, wobei jeder Abschnitt des oberen Teils in dem jeweiligen Loch und in einer horizontalen Richtung über dem entsprechenden Abschnitt des unteren Teils angeordnet ist, um die magnetische Kontinuität zwischen diesen beiden Teilen des Magnetringes herzustellen.

2. Ring nach Anspruch 1, bei dem die Querabmessungen, d.h. parallel zur Ebene der Metallisierungsschichten, der Übereinanderlagerung der vertikalen Abschnitte (176, 178, 180, 182) um mindestens 5 µm kleiner sind als die entsprechenden Querabmessungen der Löcher (30, 32) oder einer starren Führung, die im Inneren dieser Löcher angeordnet ist, um ein Spiel zwischen vertikalen Wänden des Loches oder der starren Führung und vertikalen Seiten gegenüber dem Magnetring auszusparen.

3. Ring nach einem der vorhergehenden Ansprüche, bei dem:
- die Löcher (30, 32) länglich sind und sich entlang einer selben horizontalen Ausrichtungsachse erstrecken, und
- sich jeder "U-förmige" Teil (172, 174) im Wesentlichen in einer Vertikalebene parallel zur Wickelachse erstreckt.

4. Ring nach einem der vorhergehenden Ansprüche, bei dem elektrisch isolierendes Material zwischen den übereinander gelagerten Abschnitten der unteren und oberen Teile angeordnet ist, um sie elektrisch voneinander zu isolieren.

5. Ring nach einem der vorhergehenden Ansprüche, wobei
- der Ring eine zweite Spule (39) umfasst, die um eine zweite vertikale Wickelachse (36) gewickelt ist, wobei die Windungen dieser zweiten Spule von leitenden Spuren gebildet sind, die in den Metallisierungsschichten ausgeführt sind, die elektrisch aneinander durch Stifte, die durch mindestens eine der elektrisch isolierenden Schichten hindurchgehen, angeschlossen sind,
- sich das zweite Loch (32) entlang der zweiten Wickelachse (36) erstreckt, und
- die erste und die zweite Spule umfassen:
• eine selbe erste leitende Spur (90), die in einer ersten Metallisierungsschicht ausgeführt ist, die in eine Richtung um die erste vertikale Wickelachse (34) und in die entgegengesetzte Richtung um die zweite vertikale Wickelachse (36) gewickelt ist,
• eine selbe zweite leitende Spur (130), die in einer zweiten Metallisierungsschicht ausgeführt ist, die in eine Richtung um die erste vertikale Wickelachse (34) und in die entgegengesetzte Richtung um die zweite vertikale Wickelachse (36) gewickelt ist, und
• einen ersten Stift (96), der durch mindestens eine der Isolierschichten hindurchgeht, um die erste und die zweite leitende Spur elektrisch aneinander anzuschließen, so dass sich der Strom, wenn sie angespeist werden, in der ersten Spule in eine Richtung und in der zweiten Spule in die entgegengesetzte Richtung dreht.

6. Ring nach Anspruch 5, bei dem die Übereinanderlagerung der leitenden Spuren (90, 92, 130, 132) der ersten und zweiten Spulen (38, 39), die in einer ersten und zweiten Metallisierungsschicht ausgeführt sind, in einer Ebene parallel zu den Metallisierungsschichten ein Motiv bildet, das zwei axiale Symmetrien in Bezug zu Xund Y-Achsen aufweisen, wobei diese X- und Y-Achsen zueinander orthogonal und zu den Metallisierungsschichten parallel sind, wobei die leitende(n) Spur(en) jeder der übereinander gelagerten Metallisierungsschichten für sich alleine keine axiale Symmetrie zur X- oder Y-Achse aufweist(en).

## Claims

1. A coiled magnetic ring, this ring comprising:
- a printed circuit (4) comprising:
• a stack, along a vertical direction, of several metallization layers separated mechanically from one another by electrically insulating layers,
• at least one first coil (38) that extends along a first vertical winding axis (34), the turns of this coil being formed by conductive tracks (90, 92, 130, 132) made in respective metallization layers, electrically connected to one another by pads traversing at least one of the electrically insulating layers,
• a first and a second vertical hole (30, 32) traversing the printed circuit from side to side, the first hole (30) extending along the first vertical axis (34),
- a magnetic ring (170),
**characterized in that** the magnetic ring is formed by an upper U-shaped part (172) and a lower U-shaped part (174), each upper and lower part comprising two vertical arms (176, 178, 180, 182), each introduced into a respective hole of the printed circuit, each arm of the upper part being superimposed, within the respective hole and in a horizontal direction, on a corresponding arm of the lower part to establish magnetic continuity between these two parts of the magnetic ring.

2. The ring according to claim 1, in which the transverse dimensions, i.e., dimensions parallel to the plane of metallization layers, of a superimposition of vertical arms (176, 178, 180, 182) are smaller, by at least 5 µm, than the corresponding transverse dimensions of holes (30, 32) or of a rigid guide housed within these holes to establish clearance between the vertical walls of the hole or the rigid guide and the vertical faces facing the magnetic ring.

3. The ring according to any one of the previous claims, in which:
- the holes (30, 32) are oblong and extend along a same horizontal axis of alignment, and
- each U-shaped part (172, 174) essentially extends in a vertical plane parallel to the winding axis.

4. The ring according to any one of the previous claims, in which an electrically insulating material is interposed between the superimposed arms of the lower and upper parts to electrically insulate them from one another.

5. The ring according to any one of the previous claims, in which
- the ring comprises a second coil (39) wound around a second vertical winding axis (36), the turns of this second coil being formed by conductive tracks made in the metallization layers, electrically connected to one another by pads traversing at least one of the electrically insulating layers,
- the second hole (32) extends along the second winding axis (36), and
- the first and second coils comprise:
• a same first conductive track (90), made in a first metallization layer, wound in one direction around the first vertical winding axis (34) and wound, in the opposite direction, around the second vertical winding axis (36),
• a same second conductive track (130), made in a second metallization layer, wound in one direction around the first vertical winding axis (34) and wound, in the opposite direction, around the second vertical winding axis (36), and,
• a first pad (96) traversing at least one of the insulating layers to electrically connect the first and second conductive tracks to one another so that, when they are powered, current turns in one direction in the first coil and in the opposite direction in the second coil.

6. The ring according to claim 5, in which the superimposition, in a plane parallel to the metallization layers, of conductive tracks (90, 92, 130, 132) of first and second coils (38, 39), made in first and second metallization layers, forms a pattern presenting two axial symmetries relative to X and Y axes, these X and Y axes being orthogonal to each other and parallel to the metallization layers, the conductive track or tracks of each of the superimposed metallization layers being devoid, in themselves, of axial symmetry relative to the X or Y axis.
